# EUROPEAN PATENT SPECIFICATION

(11) **EP 2 885 957 B1**
(45) Date of publication and mention of the grant of the patent: **25.12.2019**
(21) Application number: 13830630.3
(22) Date of filing: 19.08.2013
(51) Int. Cl.: H05K 7/20, F28F 9/26

(54) **APPARATUSES FOR TRANSMITTING HEAT BETWEEN A RAIL OF RACK MOUNTED EQUIPMENT AND A CHANNEL OF A COOLING RACK ENCLOSURE, AND RELATED COMPONENTS**
VORRICHTUNGEN ZUM ÜBERTRAGEN VON WÄRME ZWISCHEN EINER SCHIENE EINER REGALMONTIERTEN VORRICHTUNG UND EINEM KANAL ZUR KÜHLUNG EINES REGALGEHÄUSES SOWIE ENTSPRECHENDE KOMPONENTEN
APPAREILS DE TRANSMISSION DE CHALEUR ENTRE UN ÉQUIPEMENT MONTÉ SUR UN RAIL DE BÂTI ET UN CANAL D'UNE ENCEINTE DE BÂTI DE REFROIDISSEMENT, AINSI QUE COMPOSANTS

(30) Priority: 20.08.2012 US 201261684856 P
(43) Date of publication of application: 24.06.2015
(73) Proprietor: ADC Technologies Inc., Montreal, H3A 0A5 (CA)
(72) Inventor: Davidson, Niall, T., Hamilton, UK ML3 8QF (GB)
(74) Representative: Lavoix
(86) International application number: PCT/IB2013/001789
(87) International publication number: WO 2014/030046

(56) References cited:
- US-A- 4 958 257
- US-A- 6 141 211
- US-A1- 2004 080 907
- US-A1- 2007 297 136
- US-A1- 2010 319 883
- US-A1- 2011 075 367

## Description

### PRIORITY APPLICATION

The present application claims priority to U.S. Patent Application Serial No. 61/684,856 filed on August 20, 2012 entitled "Cooling Electronic Equipment in a Rack Enclosure,".

### BACKGROUND

Electronic equipment generates a large amount of unwanted heat, and efficiently dissipating or recycling this unwanted heat within data centers is a major concern.

Several methods for managing this unwanted heat can be used. These methods include cooling or removing hot air exhausted from electronic equipment, liquid cooling heat generating components within equipment, and even immersing equipment into liquid coolants.

Each method has its drawbacks. Exhausting hot air from electronic equipment can require that the hot air is removed using some form of heating, ventilation and air conditioning (HVAC) system and replaced with fresh air. Exhausting hot air can alternatively require that the hot air is cooled and recycled within the data center, frequently involving the use of water chillers. This requires additional energy and equipment and introduces multiple points of failure. Liquid cooling meanwhile, while effective, can make maintenance and upgrades complex and introduces a risk of leakage within sensitive environments.

A need therefore exists to remove heat from electronic equipment deployed in data centers in an efficient manner which is low risk and versatile.

### SUMMARY

The invention concerns a rack mount computer equipment as defined in the claims. Embodiments include rack mountable equipment and a complementary cooling rack enclosure arranged to work together to transmit heat from heat generating components of the rack mountable equipment to the cooling rack enclosure. Heat from the components is transferred to the cooling rack enclosure via a coolable surface disposed in a channel of the cooling rack enclosure. The rack mountable equipment includes a rail adapted to be received by the channel in the cooling rack enclosure. A thermally conductive surface on the rail contacts the coolable surface within the channel and transfers heat from the rack mountable equipment to the cooling rack enclosure. The disclosed enclosure may be backwards compatible with existing equipment, such as standard fan cooled rack mounted equipment. One benefit of this arrangement is that, by using a structural support connection between the rail and channel as the heat transmitting mechanism, the force of gravity may be sufficient to maintain contact between the thermally conductive surface of the installed equipment and a cooled surface of the enclosure.

One exemplary embodiment discloses a rack mountable equipment of a type which can be cooled by installation into a cooling rack enclosure. The equipment comprises a heat generating component and heat transmitter.

The equipment further comprises a rail adapted to be received by a channel in an enclosure when the equipment is installed in the enclosure. The equipment further comprises a thermally conductive surface located on the rail, the thermally conductive surface thermally connected via the heat transmitter to the heat generating component.

In a not claimed embodiment, a method of cooling rack mounted equipment is disclosed.

The method comprises enabling the transmission of heat from a heat-generating component of the rack mounted equipment to a thermally conductive surface. The method further comprises configuring the thermally conductive surface such that it can be urged against a cooled surface of a cooling apparatus by using a magnetic fastener.

In a not claimed embodiment, a method of cooling rack mounted equipment is disclosed.

The method comprises enabling the transmission of heat from a heat-generating component of the rack mounted equipment to a thermally conductive surface. The method further comprises configuring the thermally conductive surface such that it can be urged against a cooled surface of a cooling apparatus by using a magnetic fastener.

In a not claimed embodiment, a method of cooling rack mounted equipment is disclosed. The method comprises positioning a magnetically attractive feature such that a thermally conductive surface can be urged against a cooled surface by a magnetic fastener cooperating with the magnetically attractive feature.

### DRAWINGS

These and other features, aspects, and advantages of embodiments of the present disclosure will become better understood with regard to the following description, appended claims, and accompanying drawings where:
Figures 1 and 2 show views of a thermal connector, not according to the claimed object, designed to be urged against a counterpart surface by a magnetic fastener;
Figure 3 shows a computer system, not according to the claimed object, with the thermal connector of Figure 1, the computer system of a type suitable for installation in a shelf-style rack enclosure;
Figure 4 shows an exploded view of an liquid cooled apparatus, not according to the claimed object, designed to operate with the thermal connector of Figure 1 ;
Figure 5 shows an end view of the apparatus of Figure 4;
Figure 6 shows a view of a magnetic fastener, not according to the claimed object, suitable for use with the thermal connector of Figure 1;
Figure 7 illustrates the not-claimed magnetic fastener of Figure 6 being used to urge a thermal connector against a magnetically attractive surface;
Figure 8 shows the not claimed apparatus of Figure 4 integrated with a shelf-style rack enclosure and the computer system of Figure 3 installed therein;
Figures 9 and 10 show views of an exemplary thermal connector designed to be received by an aperture of a cooling apparatus;
Figure 11 shows an exemplary dual processor computer system with the thermal connector of Figures 9 and 10, the computer system of a type suitable for installation in a shelf-style rack enclosure;
Figure 12 shows an exemplary flat spring insert suitable for urging the thermal connector of Figures 9 and 10 against the cooled surface of a cooling apparatus;
Figures 13 and 14 show the computer system of Figure 11 installed in a shelf-style rack enclosure incorporating apertures configured to receive the thermal connector of Figures 9 and 10;
Figure 15 shows an exemplary computer system in a 3U enclosure with a pair of thermal connector rails which are configured to be received by apertures in a rack enclosure; and
Figures 16 and 17 show the computer system of Figure 15 installed in a rack enclosure, the rack enclosure having apertures configured to receive and cool the thermal connector rails.

### DETAILED DESCRIPTION

Embodiments include rack mountable equipment and a complementary cooling rack enclosure arranged to work together to transmit heat from heat generating components of the rack mountable equipment to the cooling rack enclosure. Heat from the components is transferred to the cooling rack enclosure via a coolable surface disposed in a channel of the cooling rack enclosure. The rack mountable equipment includes a rail adapted to be received by the channel in the cooling rack enclosure. A thermally conductive surface on the rail contacts the coolable surface within the channel and transfers heat from the rack mountable equipment to the cooling rack enclosure. The disclosed enclosure may be backwards compatible with existing equipment, such as standard fan cooled rack mounted equipment. One benefit of this arrangement is that, by using a structural support connection between the rail and channel as the heat transmitting mechanism, the force of gravity may be sufficient to maintain contact between the thermally conductive surface of the installed equipment and a cooled surface of the enclosure.

It is intended that the following description and claims should be interpreted in accordance with Webster's Third New International Dictionary, Unabridged unless otherwise indicated.

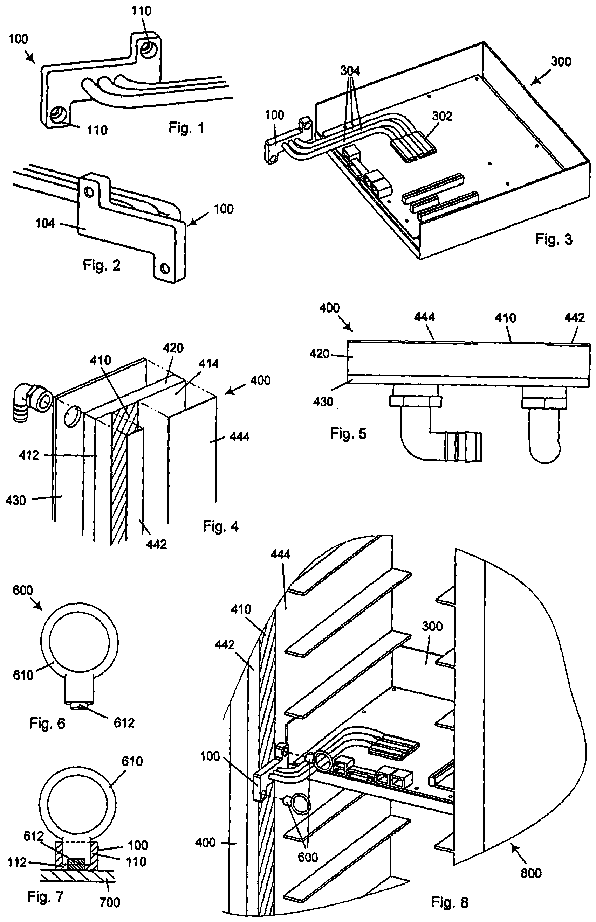

In the following specification and claims, a "thermal connector" is defined to be an apparatus, article of manufacture or portion of an apparatus or article of manufacture, the purpose of which is to transfer, transmit or communicate heat to a counterpart thermal connector when contacted with or otherwise interacting with the counterpart thermal connector. Examples of thermal connectors are shown in Figures 1, 2, 9, 10 and 15. It is not intended that the definition of a thermal connector be limited to the shape and form of the examples shown and described, nor that they are limited to operating via physical contact; nor is it necessary that a thermal connector is distinct. A thermal connector may, for instance, be a portion of a surface of an enclosure which is brought into contact with a counterpart surface to transfer, transmit or communicate heat. A person having ordinary skill in the art will be able to devise numerous and diverse thermal connectors which can be used by apparatuses embodying features of embodiments of the present disclosure.

It is intended that a "thermal connector" as defined above is interpreted to include a surface which is configured, adapted, or otherwise intended to be contacted by another surface for the purpose of communicating heat between the surfaces.

In the following specification and claims, a "heat transmitting means" is intended to encompass heatpipes, vapor chambers, thermosyphons, thermal interface materials, and thermally conductive materials, composites, manufactures and apparatus such as: thermally conductive metals, examples of which include copper, aluminium, beryllium, silver, gold, nickel and alloys thereof; thermally conductive non-metallic materials, examples of which include diamond, carbon fiber, carbon nanotubes, graphene, graphite and combinations thereof; composite materials and manufactures, examples of which include graphite fiber/copper matrix composites and encapsulated graphite systems; and apparatuses such as liquid circulation, heat pumps and heat exchangers. A "heat transmitting means" is further intended to encompass any means presently existing or that is discovered in the future which transmits heat from one place to another.

Apparatuses for cooling shelf-style rack mounted equipment using a thermal connector and magnetic fasteners are disclosed. The apparatus comprises a thermally conductive surface thermally connected to a heat generating component such as a computer processing unit (CPU) via a heat transmitter such as a heatpipe. The thermally conductive surface is configured to be urged against a cooled surface by a magnetic fastener when the equipment is installed.

Figures 1 and 2 show a thermal connector 100, not according to the claimed object, which is designed to be held against a cooled surface by magnetic fasteners. The thermal connector 100 comprises a thermally conductive surface 104 which can be contacted to a cooled surface to enable heat communication, and apertures 110 into which magnetic fasteners are inserted to urge the thermal connector against a surface. The thermal connector 100 has a thermally conductive surface manufactured from a thermally conductive material.

Figure 3 illustrates the not claimed thermal connector of Figures 1 and 2 thermally connected via a heat transmitting means to a heat-generating component of a computer system 300 in a tray type chassis suitable for installation in a shelf-style rack enclosure. The thermally conductive surface 104 of the thermal connector 100 is thermally connected via a plurality of heat pipes 304 to a CPU 302, when in operation. Heat generated by the CPU is transmitted via the heat pipes 304 to the thermally conductive surface 104. By cooling the thermally conductive surface 104, the CPU 302 can be maintained within thermal parameters. In some embodiments, using flexible heatpipes (bellows type or other) may allow the thermally conductive surface 104 to be more easily urged against a counterpart surface.

Figure 4 shows an exploded view of one end of a not-claimed apparatus 400 designed to cool the thermally conductive surface 104. The apparatus 400 comprises a part 420 comprising a thermally conductive surface 410 and recessed surfaces 412 and 414, which are parallel to and recessed below the surface 410. Plates 442 and 444 are made from a magnetically attractive material. The plates are configured to fit into the recessed surfaces 412 and 414 such that the surface 410 and surfaces 412 of the plates 442 and 444 form a uniform surface. A lid 430 is provided as a seal from the outside environment.

Figure 5 shows a view from one end of the not-claimed assembled apparatus 400, and illustrates the uniform surface created by surface 410 and plates 442 and 444. The uniform surface is configured to be contacted by one or more thermal connectors of the type shown in Figures 1 and 2. While the example described attempts to provide a uniform surface, alternate configurations of both thermal connector and cooling apparatus surfaces, including, for example, non-uniform surfaces, can be devised.

The recessed surfaces 412 and 414 of the part 420 are configured such that a thermal connector 100, which has apertures 110 a certain distance apart, can be fastened by a magnetic fastening means 600 to the magnetically attractive plates 442 and 444 while maximizing contact with the surface 410. The magnetically attractive plates are fastened to the part 420 by means of an adhesive or other fastening means such as screws. Optionally, the use of a thermal adhesive can improve heat conduction between thermal connectors contacting the magnetically attractive plate and the part 420. Alternatives to the magnetically attractive plates of apparatus 400 include constructing the cooling apparatus entirely from magnetically attractive materials or providing magnetically attractive features positioned only where required to provide fastening points.

The part 420 has a series of channels beneath the surface 410 which are configured such that a liquid coolant can flow beneath and cool any thermal connectors contacted to the surface 410. In this embodiment, the channels are sealed from the outside environment by the lid 430. In some embodiments, configuring the channels such that coolant flows in parallel beneath thermal connectors will allow each thermal connector being cooled to be cooled independently of others.

Figure 6 illustrates a not-claimed magnetic fastener 600 suitable for use with the thermal connector 100 and apparatus 400. The magnetic fastener 600 comprises a magnet 612 and body 610 designed to aid removal. The use of the magnetic fastener 600 is illustrated by Figure 7, which shows a magnetic fastener 600 being used to urge a thermal connector 100 against a magnetically attractive material 700. The magnetic fastener 600 is inserted into the aperture 110 of the thermal connector 100. The aperture 110 comprises a shelf 112 which allows the magnet 612 of the magnetic fastener 600 to pass through and be brought into proximity to the surface 700 while the body 610 of the magnetic fastener is brought into contact with the shelf 112. The force developed between the magnet 612 and the surface 700 urges the thermal connector 100 against the surface 700.

Figure 8 shows an example of the not-claimed apparatus 400 integrated with a shelf-style rack enclosure 800. The computer system 300 is shown installed with the thermal connector 100 contacted to the apparatus 400 and urged against the surface 410 by magnetic fasteners 600. Figure 8 illustrates how the magnetically attractive plates 442 and 444 are positioned to allow the thermal connector 100 to be urged against the surface by magnetic fasteners 600 while contacting a large area of surface 410 with the thermally conductive surface 104 of the thermal connector 100.

Other toolless fasteners that may be used in place of magnetic fasteners include, but are not limited to, latches, thumbscrews, and non-screw rotating fasteners which fasten and generate a pulling force along the axis of rotation.

Another apparatus for cooling shelf-style rack mounted equipment is disclosed, the apparatus comprising a thermal connector which is thermally connected to a heat generating component via a heat transmitting means such as a heatpipe. The thermal connector is configured to be received by an aperture in a cooling apparatus when the equipment is installed.

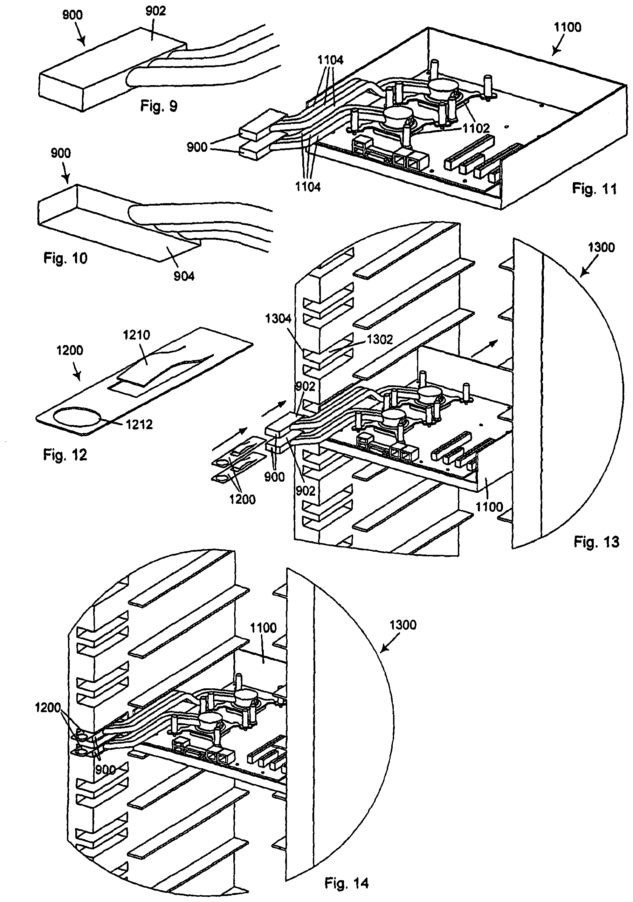

Figures 9 and 10 illustrate a thermal connector 900 which is configured to be received by an aperture in a cooling apparatus, Figure 9 shows a view of the top surface 902 and Figure 10 shows a view of the bottom surface 904 which is thermally conductive. For the example illustrated by Figure 9 and 19, each surface 902 and 904 is a flat surface and is designed to cooperate with the cooling apparatus such that, when the thermal connector 900 is positioned within the aperture of the cooling apparatus, the surface 904 can be urged against a flat counterpart surface of the cooling apparatus by a flat spring, which is inserted between the top surface 902 and a surface of the cooling apparatus. This functionality is further illustrated in Figure 13 and 14, discussed below.

Alternatives to the thermal connector 900 and cooling apparatus described include, but are not limited to, using other profiles for the contacting surfaces or using alternative urging means. One example includes configuring a part of the cooling apparatus such that it can be moved to clamp a thermal connector against a counterpart surface. Another example includes configuring a part of the thermal connector such that it can be moved to urge a surface of the thermal connector against a surface of the counterpart cooling apparatus. Another example includes configuring the cooling apparatus and thermal connector such that the thermal connector comprises one or more heatpipes, which are received by a profiled surface of the cooling apparatus such that each heatpipe can be clamped by a movable part of the cooling apparatus.

Figure 11 illustrates a dual processor computer system 1100 in a tray type chassis suitable for installation in a shelf-style rack enclosure. The computer system 1100 comprises thermal connectors 900 thermally connected to each CPU 1102 via a plurality of heatpipes 1104.

Figure 12 illustrates a flat spring insert 1200. The insert comprises a spring portion 1210 and an opening 1212 which aids with removal and insertion of the insert.

Figures 13 and 14 show a shelf-style rack enclosure 1300 with a plurality of apertures 1304 configured to receive one or more thermal connectors 900. Each aperture 1304 comprises a cooled surface 1302 against which a thermal connector 900 can be urged by a means such as spring insert 1200. Figure 13 illustrates the computer system 1100 being installed in a shelf. Each thermal connector 900 of the computer system 1100 aligns with an aperture 1304 of the enclosure 1300.

Figure 14 shows the computer system 1100 in its installed position in the shelf-style rack enclosure. Each thermal connector 900 is received by an aperture 1304 and the surfaces 904 are urged against the cooled surfaces 1302 by spring inserts 1200.

The cooled surface 1302 of each aperture 1304 of the enclosure 1300 may be cooled by any cooling means. One example of achieving cooling is to pass a liquid coolant beneath each cooled surface 1302. In this way, heat can be removed from the thermal connectors 900 being urged against the surface 1302 in an efficient manner and transported for later dissipation. This yields the benefit of liquid cooling with a significantly reduced risk of leak, and does not create significant difficulties with respect to maintaining or replacing equipment installed in the enclosure.

In another embodiment, another apparatus for cooling rack mounted equipment is disclosed. The apparatus comprises a pair of rail thermal connectors which are thermally connected to one or more heat generating components via a heat transmitting means, such as a heatpipe. In this embodiment, the rail thermal connectors are configured to be received by an aperture in a cooling apparatus when the equipment is installed, and optionally support some or all of the weight of the equipment.

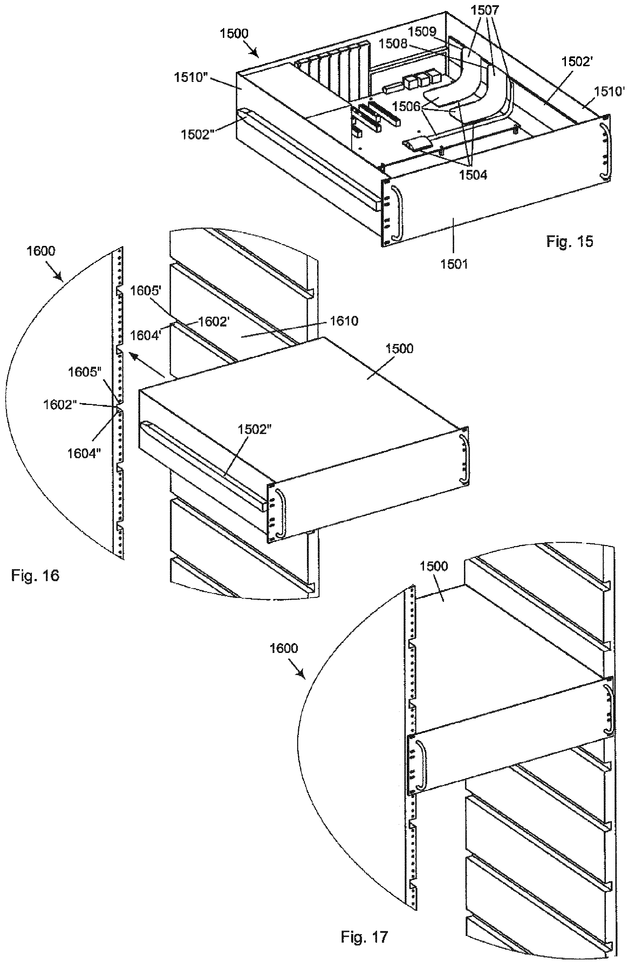

Figure 15 illustrates a computer system 1500 in a 3U enclosure. The computer system 1500 comprises a pair of rail thermal connectors 1502, one on each side of the enclosure, to which a plurality of heat generating components 1504 are thermally connected by heat transmitting means in the form of heatpipes 1506. The rail thermal connectors 1502 have a thermally conductive surface on at least the surface of the rail which is to be urged or braced against a cooled surface. The heat generating components 1504 are thermally connected to this surface by the heat transmitting means.

Figure 16 shows the computer system 1500 being installed in a rack enclosure 1600. The rack enclosure 1600 has a plurality of apertures 1602, e.g., U-shaped channels, which are designed to receive the rail thermal connectors 1502. Each aperture 1602 comprises a cooled surface 1604. Figure 17 shows the computer system 1500 installed in the rack enclosure 1600. The weight of the computer system 1500 urges the rail thermal connector 1502 against the surface 1604. Additional force may be applied if the weight is not sufficient to create an adequate thermal connection, or if the rail is not intended to support weight. For example, an apparatus may be used which allows for the rail thermal connector to be urged against the surface 1604 by turning a handle or pulling/pushing a lever to move a part and urge the thermally conductive surface of the rail against the surface 1604. The cooled surface 1604 can be cooled in a fashion similar to that of surface 1302 described above. The rack enclosure 1600 of Figures 16 and 17 offers an advantage that both legacy equipment and equipment with rail thermal connectors can be installed in the same rack enclosure without interfering with the operation of the other type.

The above embodiments have a number of advantages. For example, quick and easy installation of equipment into a rack enclosure is enabled, with no complex fittings or fasteners needed during installation. Another advantage of the above embodiments is that an urging force can urge the thermally conductive surface of installed equipment against the cooled surface of the enclosure without inducing stress or strain in the body of the installed equipment. Instead, in many embodiment, the only force against the equipment is maintained as a clamping action operating on the thermal connector while avoiding putting significant stress or strain on the body of the installed equipment.

In addition, by disposing heat exchanging surfaces on both the equipment and the enclosure as disclosed, non-flexible heat transmitting means, e.g. fixed heat pipes, can be used to transmit heat to both sides of the equipment. Additionally, as disclosed in one embodiment above, the force of gravity may be sufficient to maintain contact between the thermally conductive surface of the installed equipment and a cooled surface of the enclosure.

While some of the examples described disclose thermal connectors which are similarly positioned relative to the example computer systems, it is not intended that apparatuses embodying principles of the present disclosure are required to have such positioning. Further, it is not intended that the teachings of the present disclosure are limited to computer systems, a specific form of enclosure, or a specific type of heat-generating component, and it is expected that principles of the present disclosure can be applied to other forms of apparatus.

Although specific embodiments of the disclosure have been shown and described herein, it is to be understood that these embodiments are merely illustrative of the many possible specific arrangements that can be devised in application of the principles of the disclosure. Numerous and varied other arrangements can be devised by those of ordinary skill in the art without departing from the scope as defined by the claims.

## Claims

1. A rack mount computer equipment (1500) configured for installation into a data center, the rack mount equipment (1500) comprising:
a) a chassis (1501) comprising a plurality of sides (1510);
b) a plurality of heat generating components (1504), each of the heat generating components (1504) being installed within the chassis (1501);
c) a plurality of heat transmitters (1506), each of the heat transmitters (1506) being thermally connected to at least one of the plurality of heat generating components (1504);
d) a first rail thermal connector (1502') projecting from a first of the sides (1510') of the chassis (1501),
a portion (1507) of each of the plurality of heat transmitters (1506) being contacted to the first rail thermal connector (1502') and arranged along the length of the first rail thermal connector (1502') in such a way that each portion of each of the plurality of heat transmitters (1506) is contacted to a different area of the first rail thermal connector (1502'),
the first rail thermal connector (1502') being configured to be received by a counterpart channel (1602') in a rack enclosure (1600) when the rack mount computer equipment (1500) is installed in the rack enclosure (1600), the counterpart channel (1602') comprising a first surface (1604') and a second surface (1605') opposite the first surface (1604'); and
e) an urging means operable to urge the first rail thermal connector (1502') against the first surface (1604') of the counterpart channel (1602') once the rack mount computer equipment (1500) has been installed in the rack enclosure (1600),
the rack mount computer equipment (1500) being configured such that, once the rack mount computer equipment (1500) has been installed within the rack enclosure (1600), the urging means can be operated to apply an urging force against the first rail thermal connector (1502') to urge the first rail thermal connector (1502') against the first surface (1604') of the counterpart channel (1602') without inducing stress or strain in the body of the installed rack mount computer equipment (1500).

2. The rack mount computer equipment (1500) of claim 1, the rack mount computer equipment (1500) further comprising:
f) a second rail thermal connector (1502") projecting from a second of the sides (1510") of the chassis (1501), the second side (1510") being opposite to the first side (1510'),
the rack enclosure (1600) comprising a second counterpart channel (1602") and the second rail thermal connector (1502") being configured to be received by the second counterpart channel (1602") when the rack mount computer equipment (1500) is installed in the rack enclosure (1600);
the second counterpart channel (1602") comprising a third surface (1604") and a fourth surface (1605"), the fourth surface (1605") being opposite to the third surface (1604");
the rack mount computer equipment (1500) being configured such that, once the rack mount computer equipment (1500) has been installed within the rack enclosure (1600), the urging means can be operated to urge the first rail thermal connector (1502') against the first surface (1604') of the counterpart channel (1602') and to urge the second rail thermal connector (1502") against the third surface (1604") of the second counterpart channel (1602") without inducing stress or strain in the body of the installed rack mount computer equipment (1500).

3. The rack mount computer equipment (1500) of claim 2, the rack mount computer equipment (1500) further comprising:
g) a second plurality of heat transmitters (1506), each being thermally connected to at least one of the plurality of heat generating components (1504),
a portion (1507) of each of the second plurality of heat transmitters (1506) being contacted to the second rail thermal connector (1502"') and arranged along the length of the second rail thermal connector (1502") in such a way that each portion (1507) of each of the second plurality of heat transmitters (1506) is contacted to a different area of the second rail thermal connector (1502").

4. The rack mount computer equipment (1500) of any of claims 1 to 3, wherein the first rail thermal connector (1502') is a fixed body and is fixed with respect to the chassis (1501) and at least one of the plurality of heat transmitters (1506) is fixably mounted to the first rail thermal connector (1502') to provide a thermal path allowing heat to travel via the at least one of the plurality of heat transmitters (1506) from at least one of the heat generating components (1504) to the surface of the first rail thermal connector (1502') being urged against the first surface (1604') crossing only fixed thermal interfaces.

5. The rack mount computer equipment (1500) of any of claims 1 to 4, wherein the urging means is configured to be operable to urge the first rail thermal connector (1502') against the first surface (1604') of the counterpart channel (1602') by urging the first rail thermal connector (1502') in a direction substantially normal to the first surface (1604').

6. The rack mount computer equipment (1500) of claim 1, wherein the urging means comprises a spring (1200) located between the first rail thermal connector (1502') and the second surface (1605') of the counterpart channel (1602') when the rack mount computer equipment (1500) is installed in the rack enclosure (1600).

7. The rack mount computer equipment (1500) of claim 1, wherein the urging means comprises a handle or lever, and the urging means is configured such that, once the rack mount computer equipment (1500) has been installed within the rack enclosure (1600), turning the handle or pulling/pushing the lever moves a part to urge the first rail thermal connector (1502') against the first surface (1604').

8. The rack mount computer equipment (1500) of claim 7, the urging means being configured in such a way that, when the rack mount equipment (1500) has been installed in the rack enclosure (1600), operating the urging means to urge the first rail thermal connector (1502') against the first surface (1604') of the counterpart channel (1602') engenders movement of the chassis (1501) or movement of the first rail thermal connector (1502') only in a direction substantially normal to the first surface (1604').

9. The rack mount computer equipment (1500) of any of claims 7 or 8, the first rail thermal connector (1502') further comprising a movable portion, wherein turning the handle or pulling/pushing the lever causes the movable portion to urge the first rail thermal connector (1502') against the first surface (1604') by being braced against the second surface (1605') when the rack mount computer equipment (1500) is installed in the rack enclosure (1600).

10. The rack mount computer equipment (1500) of any of claims 7 to 9, wherein the first rail thermal connector (1502') is immovable relative to the chassis (1501) in a direction normal to the first side (1510') of the chassis (1501) that the first rail thermal connector (1502') protrudes from.

## Patentansprüche

1. Regalmontage-Computerausrüstung (1500), konfiguriert für die Installation in einem Datenzentrum, wobei die Regalmontage-Computerausrüstung (1500) aufweist:
a) ein Gehäuse (1501), das eine Mehrzahl von Seiten (1510) hat,
b) eine Mehrzahl von wärmeerzeugenden Komponenten (1504), wobei jede der wärmeerzeugenden Komponenten (1504) in dem Gehäuse (1501) installiert ist,
c) eine Mehrzahl von Wärmeüberträgern (1506), wobei jeder der Wärmeüberträger (1506) thermisch mit wenigstens einer der Mehrzahl von wärmeerzeugenden Komponenten (1504) verbunden ist,
d) einen ersten Schiene-Thermoverbinder (1502'), der von einer ersten der Seiten (1510') des Gehäuses (1501) aus vorsteht,
wobei ein Abschnitt (1507) von jedem der Mehrzahl von Wärmeüberträgern (1506) mit dem ersten Schiene-Thermoverbinder (1502') kontaktiert ist und entlang der Länge des ersten Schiene-Thermoverbinders (1502') angeordnet ist, sodass jeder Abschnitt von jedem der Mehrzahl von Wärmeüberträgern (1506) mit einem unterschiedlichen Bereich des ersten Schiene-Thermoverbinders (1502') kontaktiert ist,
wobei der erste Schiene-Thermoverbinder (1502') konfiguriert ist, um von einem Gegenstück-Kanal (1602') in einer Regaleinfassung (1600) aufgenommen zu werden, wenn die Regalmontage-Computerausrüstung (1500) in der Regaleinfassung (1600) installiert ist, wobei der Gegenstück-Kanal (1602') eine erste Fläche (1604') und eine zweite Fläche (1605') gegenüberliegend zu der ersten Fläche (1604') aufweist, und
e) ein Zwingmittel, das betreibbar ist, um den ersten Schiene-Thermoverbinder (1502') gegen die erste Fläche (1604') des Gegenstück-Kanals (1602') zu zwingen, sobald die Regalmontage-Computerausrüstung (1500) in der Regaleinfassung (1600) installiert worden ist,
wobei die Regalmontage-Computerausrüstung (1500) derart konfiguriert ist, dass, sobald die Regalmontage-Computerausrüstung (1500) in der Regaleinfassung (1600) installiert worden ist, das Zwingmittel betrieben werden kann, um eine Zwingkraft gegen den ersten Schiene-Thermoverbinder (1502') aufzubringen, um den ersten Schiene-Thermoverbinder (1502') gegen die erste Fläche (1604') des Gegenstück-Kanals (1602') zu zwingen, ohne Belastung und Spannung in dem Körper der installierten Regalmontage-Computerausrüstung (1500) hervorzurufen.

2. Regalmontage-Computerausrüstung (1500) gemäß Anspruch 1, wobei die Regalmontage-Computerausrüstung (1500) ferner aufweist:
f) einen zweiten Schiene-Thermoverbinder (1502'), der von einer zweiten der Seiten (1510") des Gehäuses (1501) aus vorsteht, wobei die zweite Seite (1510") entgegengesetzt zu der ersten Seite (1510') ist,
wobei die Regaleinfassung (1600) einen zweiten Gegenstück-Kanal (1602") aufweist und der zweite Schiene-Thermoverbinder (1502") konfiguriert ist, um von dem zweiten Gegenstück-Kanal (1602") aufgenommen zu werden, wenn die Regalmontage-Computerausrüstung (1500) in der Regaleinfassung (1600) installiert ist,
wobei der zweite Gegenstück-Kanal (1602") aufweist eine dritte Fläche (1604") und eine vierte Fläche (1605"), wobei die vierte Fläche (1605") der dritten Fläche (1604") gegenüberliegt,
wobei die Regalmontage-Computerausrüstung (1500) konfiguriert ist, sodass, sobald die Regalmontage-Computerausrüstung (1500) in der Regaleinfassung (1600) installiert worden ist, das Zwingmittel betrieben werden kann, um den ersten Schiene-Thermoverbinder (1502') gegen die erste Fläche (1604') des Gegenstück-Kanals (1602') zu zwingen und um den zweiten Schiene-Thermoverbinder (1502") gegen die dritte Fläche (1604") des zweiten Gegenstück-Kanals (1602") zu zwingen, ohne Belastung und Spannung in dem Körper der installierten Regalmontage-Computerausrüstung (1500) hervorzurufen.

3. Regalmontage-Computerausrüstung (1500) gemäß Anspruch 2, wobei die Regalmontage-Computerausrüstung (1500) ferner aufweist:
g) eine zweite Mehrzahl von Wärmeüberträgern (1506), von denen jeder thermisch mit wenigstens einer der Mehrzahl von wärmeerzeugenden Komponenten (1504) verbunden ist,
wobei ein Abschnitt (1507) von jedem der zweiten Mehrzahl von Wärmeüberträgern (1506) mit dem zweiten Schiene-Thermoverbinder (1502") kontaktiert und entlang der Länge des zweiten Schiene-Thermoverbinders (1502") angeordnet ist, sodass jeder Abschnitt (1507) jedes der zweiten Mehrzahl von Wärmeüberträgern (1506) mit einem unterschiedlichen Bereich des zweiten Schiene-Thermoverbinders (1502") kontaktiert ist.

4. Regalmontage-Computerausrüstung (1500) gemäß irgendeinem der Ansprüche 1 bis 3, wobei der erste Schiene-Thermoverbinder (1502') ein fixierter Körper ist und bezüglich des Gehäuses (1501) fixiert ist, und wenigstens einer der Mehrzahl von Wärmeüberträgern (1506) an dem ersten Schiene-Thermoverbinder (1502') festmontiert ist, um einen Thermopfad bereitzustellen, der es Wärme ermöglicht, über den wenigstens einen der Mehrzahl von Wärmeüberträgern (1506) von wenigstens einer der wärmeerzeugenden Komponenten (1504) aus zu der Fläche des ersten Schiene-Thermoverbinders (1502') zu wandern, der gegen die erste Fläche (1604') gezwungen ist, nur fixierte Thermoschnittstellen durchquerend.

5. Regalmontage-Computerausrüstung (1500) gemäß irgendeinem der Ansprüche 1 bis 4, wobei das Zwingmittel konfiguriert ist, um betreibbar zu sein, um den ersten Schiene-Thermoverbinder (1502') gegen die erste Fläche (1604') des Gegenstück-Kanals (1602') zu zwingen durch Zwingen des ersten Schiene-Thermoverbinders (1502') in eine Richtung im Wesentlichen normal zu der ersten Fläche (1604').

6. Regalmontage-Computerausrüstung (1500) gemäß Anspruch 1, wobei das Zwingmittel eine Feder (1200) aufweist, die zwischen dem ersten Schiene-Thermoverbinder (1502') und der zweiten Fläche (1605') des Gegenstück-Kanals (1602') angeordnet ist, wenn die Regalmontage-Computerausrüstung (1500) in der Regaleinfassung (1600) installiert ist.

7. Regalmontage-Computerausrüstung (1500) gemäß Anspruch 1, wobei das Zwingmittel einen Handgriff oder Hebel aufweist, und wobei das Zwingmittel konfiguriert ist, sodass, sobald die Regalmontage-Computerausrüstung (1500) in der Regaleinfassung (1600) installiert worden ist, ein Drehen des Handgriffs oder ein Ziehen/Drücken des Hebels ein Teil bewegt, um den ersten Schiene-Thermoverbinder (1502') gegen die erste Fläche (1604') zu zwingen.

8. Regalmontage-Computerausrüstung (1500) gemäß Anspruch 7, wobei das Zwingmittel konfiguriert ist, sodass, wenn die Regalmontage-Computerausrüstung (1500) in der Regaleinfassung (1600) installiert ist, ein Betätigen des Zwingmittels, um den ersten Schiene-Thermoverbinder (1502') gegen die erste Fläche (1604') des Gegenstück-Kanals (1602') zu zwingen, eine Bewegung des Gehäuses (1501) oder eine Bewegung des ersten Schiene-Thermoverbinders (1502') nur in einer Richtung im Wesentlichen normal zu der ersten Fläche (1604') bewirkt.

9. Regalmontage-Computerausrüstung (1500) gemäß irgendeinem der Ansprüche 7 oder 8, wobei der erste Schiene-Thermoverbinder (1502') ferner einen bewegbaren Abschnitt aufweist, wobei das Drehen des Handgriffs oder das Ziehen/Drücken des Hebels den bewegbaren Abschnitt veranlasst, den ersten Schiene-Thermoverbinder (1502') gegen die erste Fläche (1604') zu zwingen, indem er gegen die zweite Fläche (1605') abgestützt ist, wenn die Regalmontage-Computerausrüstung (1500) in der Regaleinfassung (1600) installiert ist.

10. Regalmontage-Computerausrüstung (1500) gemäß irgendeinem der Ansprüche 7 bis 9, wobei der erste Schiene-Thermoverbinder (1502') relativ zu dem Gehäuse (1501) in eine Richtung normal zu der ersten Seite (1510') des Gehäuses (1501) unbewegbar ist, von welcher der erste Schiene-Thermoverbinder (1502') aus vorsteht.

## Revendications

1. Équipement d'ordinateur pour montage en bâti (1500) configuré pour être installé dans un centre de données, l'équipement pour montage en bâti (1500) comprenant :
a) un châssis (1501) comprenant une pluralité de côtés (1510) ;
b) une pluralité de composants de génération de chaleur (1504), chacun des composants de génération de chaleur (1504) étant installé à l'intérieur du châssis (1501) ;
c) une pluralité d'échangeurs de chaleur (1506), chacun des échangeurs de chaleur (1506) étant thermiquement raccordé à au moins l'un de la pluralité de composants de génération de chaleur (1504) ;
d) un premier connecteur thermique de rail (1502') faisant saillie à partir d'un premier des côtés (1510') du châssis (1501),
une partie (1507) de chacun de la pluralité d'échangeurs de chaleur (1506) étant en contact avec le premier connecteur thermique de rail (1502') et agencée le long de la longueur du premier connecteur thermique de rail (1502') de sorte que chaque partie de chacun de la pluralité d'échangeurs de chaleur (1506) est en contact avec une zone différente du premier connecteur thermique de rail (1502'),
le premier connecteur thermique de rail (1502') étant configuré pour être reçu par un canal de contrepartie (1602') dans une enceinte de bâti (1600) lorsque l'équipement d'ordinateur pour montage en bâti (1500) est installé dans l'enceinte de bâti (1600), le canal de contrepartie (1602') comprenant une première surface (1604') et une deuxième surface (1605') opposée à la première surface (1604') ; et
e) un moyen de poussée pouvant fonctionner pour pousser le premier connecteur thermique de rail (1502') contre la première surface (1604') du canal de contrepartie (1602'), une fois que l'équipement d'ordinateur pour montage en bâti (1500) a été installé dans l'enceinte de bâti (1600),
l'équipement d'ordinateur pour montage en bâti (1500) étant configuré de sorte que, une fois que l'équipement d'ordinateur pour montage en bâti (1500) a été installé à l'intérieur de l'enceinte de bâti (1600), le moyen de poussée peut être actionné pour appliquer une force de poussée contre le premier connecteur thermique de rail (1502') afin de pousser le premier connecteur thermique de rail (1502') contre la première surface (1604') du canal de contrepartie (1602') sans induire de tensions ou de contraintes dans le corps de l'équipement d'ordinateur pour montage en bâti (1500).

2. Équipement d'ordinateur pour montage en bâti (1500) selon la revendication 1, l'équipement d'ordinateur pour montage en bâti (1500) comprenant en outre :
f) un second connecteur thermique de rail (1502") faisant saillie d'un second des côtés (1510") du châssis (1501), le second côté (1510") étant opposé au premier côté (1510'),
l'enceinte de bâti (1600) comprenant un second canal de contrepartie (1602") et le second connecteur thermique de rail (1502") étant configuré pour être reçu par le second canal de contrepartie (1602") lorsque l'équipement d'ordinateur pour montage en bâti (1500) est installé dans l'enceinte de bâti (1600) ;
le second canal de contrepartie (1602") comprenant une troisième surface (1604") et une quatrième surface (1605"), la quatrième surface (1605") étant opposée à la troisième surface (1604") ;
l'équipement d'ordinateur pour montage en bâti (1500) étant configuré de sorte qu'une fois que l'équipement d'ordinateur pour montage en bâti (1500) a été installé à l'intérieur de l'enceinte de bâti (1600), le moyen de poussée peut être actionné pour pousser le premier connecteur thermique de rail (1502') contre la première surface (1604') du canal de contrepartie (1602') et pour pousser le second connecteur thermique de rail (1502") contre la troisième surface (1604") du second canal de contrepartie (1602") sans induire de tensions ni de contraintes dans le corps de l'équipement d'ordinateur pour montage en bâti (1500).

3. Équipement d'ordinateur pour montage en bâti (1500) selon la revendication 2, l'équipement d'ordinateur pour montage en bâti (1500) comprenant en outre :
g) une seconde pluralité d'échangeurs de chaleur (1506), chacun étant thermiquement raccordé à au moins l'un de la pluralité de composants de génération de chaleur (1504),
une partie (1507) de chacun de la seconde pluralité d'échangeurs de chaleur (1506) étant en contact avec le second connecteur thermique de rail (1502"') et agencée le long de la longueur du second connecteur thermique de rail (1502") de sorte que chaque partie (1507) de chacun de la seconde pluralité d'échangeurs de chaleur (1506) est en contact avec une zone différente du second connecteur thermique de rail (1502").

4. Équipement d'ordinateur pour montage en bâti (1500) selon l'une quelconque des revendications 1 à 3, dans lequel le premier connecteur thermique de rail (1502') est un corps fixe et est fixé par rapport au châssis (1501) et au moins l'un de la pluralité d'échangeurs de chaleur (1506) est monté de manière fixe sur le premier connecteur thermique de rail (1502') pour fournir une trajectoire thermique permettant à la chaleur de se déplacer via le au moins un de la pluralité d'échangeurs de chaleur (1506) à partir d'au moins l'un des composants de génération de chaleur (1504) vers la surface du premier connecteur thermique de rail (1502') qui est poussé contre la première surface (1604') traversant uniquement les interfaces thermiques fixes.

5. Équipement d'ordinateur pour montage en bâti (1500) selon l'une quelconque des revendications 1 à 4, dans lequel le moyen de poussée est configuré pour pouvoir être actionné afin de pousser le premier connecteur thermique de rail (1502') contre la première surface (1604') du canal de contrepartie (1602') en poussant le premier connecteur thermique de rail (1502') dans une direction sensiblement normale à la première surface (1604').

6. Équipement d'ordinateur pour montage en bâti (1500) selon la revendication 1, dans lequel le moyen de poussée comprend un ressort (1200) positionné entre le premier connecteur thermique de rail (1502') et la seconde surface (1605') du canal de contrepartie (1602') lorsque l'équipement d'ordinateur pour montage en bâti (1500) est installé dans l'enceinte de bâti (1600).

7. Équipement d'ordinateur pour montage en bâti (1500) selon la revendication 1, dans lequel le moyen de poussée comprend une poignée ou un levier, et le moyen de poussée est configuré de sorte qu'une fois que l'équipement d'ordinateur pour montage en bâti (1500) a été installé à l'intérieur de l'enceinte de bâti (1600), le fait de faire tourner la poignée ou le fait de tirer/pousser le levier déplace une partie pour pousser le premier connecteur thermique de rail (1502') contre la première surface (1604').

8. Équipement d'ordinateur pour montage en bâti (1500) selon la revendication 7, le moyen de poussée étant configuré de sorte que, lorsque l'équipement d'ordinateur pour montage en bâti (1500) a été installé dans l'enceinte de bâti (1600), le fait d'actionner le moyen de poussée pour pousser le premier connecteur thermique de rail (1502') contre la première surface (1604') du canal de contrepartie (1602') engendre le mouvement du châssis (1501) ou le mouvement du premier connecteur thermique de rail (1502') uniquement dans une direction sensiblement normale à la première surface (1604').

9. Équipement d'ordinateur pour montage en bâti (1500) selon l'une quelconque des revendications 7 ou 8, le premier connecteur thermique de rail (1502') comprenant en outre une partie mobile, dans lequel la rotation de la poignée ou la traction/poussée du levier amène la partie mobile à pousser le premier connecteur thermique de rail (1502') contre la première surface (1604') en étant calée contre la deuxième surface (1605') lorsque l'équipement d'ordinateur pour montage en bâti (1500) est installé dans l'enceinte de bâti (1600).

10. Équipement d'ordinateur pour montage en bâti (1500) selon l'une quelconque des revendications 7 à 9, dans lequel le premier connecteur thermique de rail (1502') est immobile par rapport au châssis (1501) dans une direction normale au premier côté (1510') du châssis (1501) duquel le premier connecteur thermique de rail (1502') fait saillie.
